Europäisches Patentamt

European Patent Office

Office européen des brevets

(11) Numéro de publication: **0 373 066**
**A1**

## (12) DEMANDE DE BREVET EUROPEEN

(21) Numéro de dépôt: 89403368.7

(22) Date de dépôt: 05.12.89

(51) Int. Cl.5: **H01L 29/08, H01L 21/332**

(30) Priorité: 07.12.88 FR 8816062

(43) Date de publication de la demande:
**13.06.90 Bulletin 90/24**

(84) Etats contractants désignés:
**DE GB IT**

(71) Demandeur: **TELEMECANIQUE**
**43-45, Boulevard Franklin Roosevelt**
**F-92504 Rueil-Malmaison Cedex(FR)**

(72) Inventeur: **Rosetti, Pierre**
**12, Chemin Renaudin**
**F-92260 Fontenay Aux Roses(FR)**
Inventeur: **Ribault, Yvette**
**31, rue Louis-Roland**
**F-92120 Montrouge(FR)**

(74) Mandataire: **Martin, Jean-Jacques et al**
**Cabinet REGIMBEAU 26, Avenue Kléber**
**F-75116 Paris(FR)**

(54) **Dispositif semiconducteur de puissance symétrique et son procédé de fabrication.**

(57) L'invention concerne un dispositif semiconducteur de puissance symétrique muni de caissons périphériques, ainsi qu'un procédé de fabrication d'un tel dispositif.

Une couche épitaxiale P(N) 23 essentiellement polycristalline affleure une face principale S1 du dispositif au moyen de sillons 21 obtenus par gravure et coiffés d'une zone périphérique P(N) 25. Une couche P(N) 22 est diffusée entre la couche 23 et une couche monocristalline N(P) 20 pour déterminer une jonction J2 que les sillons 21 et la zone 25 permettent de ramener à la face S1.

Application aux dispositifs bipolaires symétriques, en particulier aux thyristors ouvrables par la gâchette.

FIG.6

## DISPOSITIF SEMICONDUCTEUR DE PUISSANCE SYMETRIQUE ET SON PROCEDE DE FABRICATION.

La présente invention concerne un dispositif semiconducteur de puissance symétrique muni de caissons de liaison. Elle concerne aussi un procédé de fabrication d'un tel dispositif.

Un dispositif semiconducteur de puissance symétrique doit bénéficier d'une tenue en tension sensiblement identique dans les deux directions. Pour tenir une tension par exemple de l'ordre de 1000 volts, il convient en particulier de prendre des dispositions périphériques efficaces et autant que possible simples à réaliser.

Il est ainsi avantageux de n'avoir à prendre ces dispositions que sur une seule face du semiconducteur. Dans cet esprit, une méthode connue consiste à ramener la périphérie d'une jonction inférieure d'un semiconducteur de puissance vers sa face supérieure en réalisant des paires de caissons jointifs diffusés à partir de ses deux faces principales.

Pour des dispositifs haute tension, les caissons peuvent atteindre une profondeur d'au moins 200 µm, ce qui nécessite une durée de diffusion très longue. On peut accélérer la réalisation des caissons par thermo-migration d'aluminium, mais un tel procédé est difficile à mettre en oeuvre sans perturbation des autres caractéristiques du dispositif.

L'invention a pour but de ramener vers une première face d'un dispositif semiconducteur de puissance symétrique la périphérie d'une jonction située près d'une deuxième face du dispositif, en évitant les difficultés inhérentes à la diffusion profonde de caissons périphériques.

Elle vise également à faire bénéficier un tel dispositif des possibilités offertes par la technologie épitaxiale.

Le dispositif semiconducteur de puissance symétrique conforme à l'invention comprend :
- une première couche N(P) définissant une première face principale,
- une deuxième couche peu résistive P(N), d'épaisseur éventuellement supérieure à celle de la première couche, et définissant une deuxième face principale,
- la deuxième couche affleurant la première face au moyen de sillons qui viennent de gravure,
- une troisième couche P(N) formée entre la première et la deuxième couche, y compris sur les facettes des sillons, et déterminant avec la première couche une jonction,
- une quatrième couche P(N) diffusée sur la première face dans la première couche,
- une zone périphérique P(N) diffusée sur la première face de manière à coiffer les sommets des sillons et à former avec ceux-ci des caissons de liaison de la jonction avec la première face.

La périphérie de la jonction PN proche de la deuxième face est donc ramenée sur la première face, de sorte que les précautions classiques nécessaires pour assurer la tenue bidirectionnelle en tension seront prises sur un contour de la seule première face.

L'invention concerne également un procédé de réalisation du dispositif décrit à partir d'une tranche de silicium monocristallin N(P), comprenant les étapes suivantes:
- gravure de sillons, par exemple sous forme de réseau, sur un côté de la tranche constituant la première couche,
- dépôt épais d'une deuxième couche de silicium P(N) de préférence par un processus du genre épitaxial sur le côté de la tranche dans lequel ont été gravés les sillons,
- rodage de la tranche jusqu'à une première face principale qui affleure approximativement les sommets des sillons,
- diffusion P(N) sur la première face principale de la quatrième couche entourée par les sillons et diffusion de la zone périphérique coiffant les sommets des sillons.

La couche épitaxiale P(N) est essentiellement polycristalline. Elle est, soit fortement dopée lors du dépôt, soit faiblement dopée lors du dépôt; dans ce dernier cas, elle est surdopée par une diffusion ultérieure à partir de la deuxième face principale, par exemple simultanément à la diffusion de la quatrième couche et de la zone périphérique.

La troisième couche P(N) intermédiaire entre la première et la deuxième couche est formée, soit par diffusion immédiatement après la gravure des sillons, soit par diffusion à partir de la deuxième couche lorsque celle-ci est suffisamment dopée, par exemple simultanément à la diffusion de la quatrième couche et de la zone périphérique.

D'autres aspects, buts et avantages de l'invention apparaîtront mieux à la lecture de la description qui suit d'un exemple de réalisation non limitatif, en regard des dessins annexés.

La figure 1 est la coupe schématique d'un semiconducteur de puissance muni de caissons de liaison réalisés selon une technique classique de diffusion profonde.

Les figures 2 à 7 montrent des étapes de fabrication d'un semiconducteur de puissance symétrique du type thyristor selon l'invention.

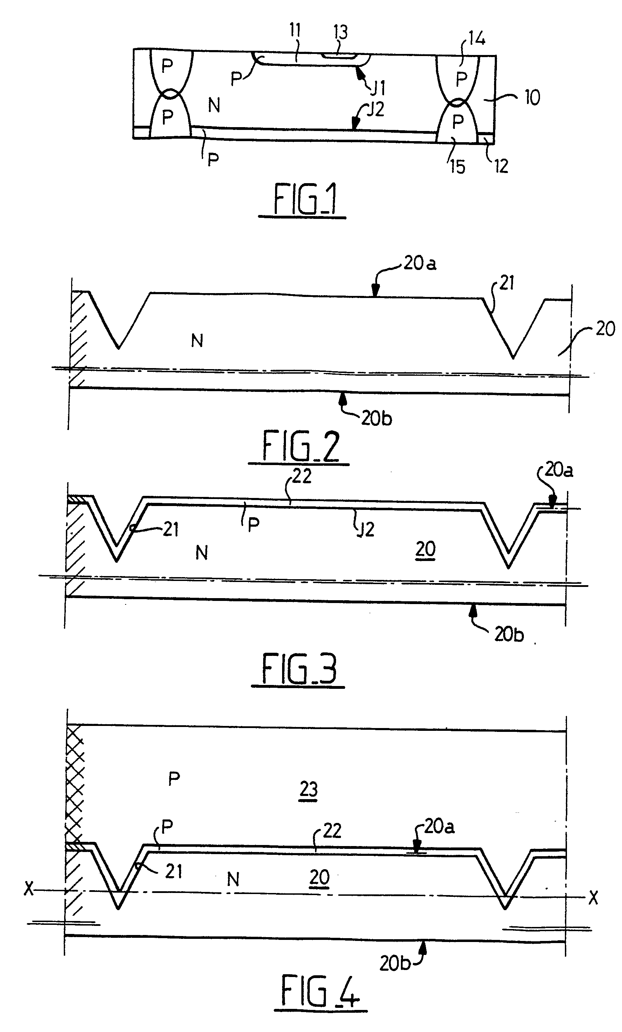

Le dispositif classique de la figure 1 comprend un substrat N 10 dans lequel sont pratiquées une diffusion P 11 sur une partie d'une première face (face supérieure) et une diffusion P 12 sur une deuxième face (face inférieure). Une diffusion N 13 est pratiquée dans la couche 11. Des caissons mutuellement en regard 14, 15 sont diffusés autour de la zone 11 de manière à se rejoindre et à ramener la jonction PN J2 existant entre les zones 12 et 10 vers la face supérieure du dispositif. Chaque caisson est diffusé sur une profondeur supérieure à la moitié de l'épaisseur totale, ce qui implique les inconvénients précédemment exposés.

Le dispositif semiconducteur de puissance symétrique selon l'invention s'obtient à partir d'une tranche 20 de silicium monocristallin dopé N (figure 2). Les types de dopage ici considérés peuvent bien entendu être intervertis. on grave par un procédé approprié utilisant la voie sèche ou humide des sillons 21 profonds par exemple en forme de V sur une face 20a de la tranche. Les sillons 21 peuvent également être gravés en forme de U. Ainsi, par gravure anisotropique à la potasse sur un silicium orienté <100>, on peut obtenir des sillons 21 de profondeur supérieure à 200 $\mu$m. En pratique, les sillons 21 auront une profondeur égale à celle de la zone active du dispositif.

L'étape suivante consiste (figure 3) à diffuser sur la face 20a de la tranche une couche P 22 de manière à créer l'homojonction J2. La couche 22 peut avoir une épaisseur de l'ordre de 10$\mu$m. Cette étape est facultative comme on le verra plus loin; elle a notamment l'avantage de permettre une bonne reproductibilité de la région de base 22.

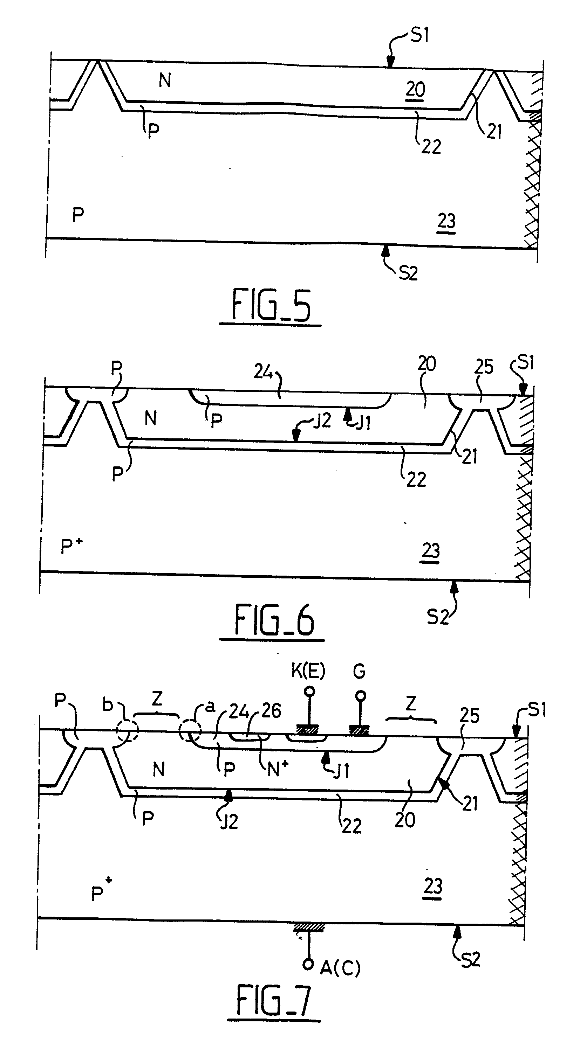

Ensuite (voir figure 4), on dépose une couche épaisse de silicium P 23 sur la couche P 22 ou, en l'absence de celle-ci, sur la face 20a de la tranche monocristalline. Le dépôt 23 est obtenu par un procédé du genre épitaxial. On laisse l'épitaxie se dérouler pour engendrer une couche P essentiellement polycristalline, c'est-à-dire monocristalline sur une faible épaisseur puis polycristalline dans sa majeure partie; outre la rapidité, ce mode opératoire comporte des avantages explicités plus loin. L'épaisseur de la couche épitaxiale 23 peut être de l'ordre de 200 à 400 $\mu$m.

La couche monocristalline 20 est rodée ou polie de sa face 20b jusqu'à un plan X-X (figure 4) affleurant les sommets des sillons 21, ce qui détermine une première face principale S1 pour le dispositif (figure 5), tandis que la deuxième face principale S2 du dispositif est constituée par une surface de la couche épitaxiale 23. L'affleurement des sommets des sillons n'est pas critique du fait de la diffusion qui va ensuite être réalisée sur ces sommets.

On procède ensuite à une diffusion P sur la face S1 pour créer d'une part une région P 24 comprise entre les sillons 21 et formant avec la région N 20 une jonction J1, d'autre part des caissons périphériques 25 coiffant les sillons 21 de façon à constituer avec eux les caissons de liaison recherchés (figure 6). En variante, les régions 24 et les caissons 25 peuvent être diffusés séparément.

Si le dopage de la couche épitaxiale 23 est modéré, on surdope cette couche par diffusion P + à partir de la face S2, de préférence simultanément à la diffusion des zones 24, 25 sur la face S1. On bénéficie alors du fait que la diffusion des impuretés dans la couche 23 en silicium polycristallin est beaucoup plus rapide que dans la couche 20 en silicium monocristallin.

Dans la variante de réalisation où la couche P 22 n'a pas été diffusée immédiatement après gravure des sillons, cette couche enterrée est diffusée à partir de la couche épitaxiale 23 qui sert de source de dopants, et cela simultanément à la diffusion des zones 24, 25 lorsque la couche 23 est suffisamment dopée d'origine. la couche 22 peut également dans certains cas être diffusée à partir de la couche 23 simultanément au surdopage de celle-ci.

Dans la variante de réalisation où la couche P 22 a été diffusée immédiatement après gravure des sillons et lorsqu'on surdope la couche 23 par diffusion à partir de la face S2, la couche 22 peut avantageusement concourir au surdopage de la couche 23 du côté opposé à la face S2.

La figure 7 illustre la diffusion de zones N + 26 dans la région 24 pour obtenir un dispositif à 4 couches PNPN, par exemple du genre thyristor ouvrable par la gâchette (GTO), dont les électrodes principales sont repérées A(C), K(E) et l'électrode de commande par G. Le dispositif peut aussi être à 3 couches PNP ou NPN.

En ce qui concerne la tenue en tension inverse du dispositif, les zones critiques repérées a pour la jonction J1 et b pour la jonction J2 peuvent être ensuite protégées à l'aide de moyens classiques - anneaux de garde, plaques de champ, etc. - formés ou apportés sur la zone périphérique Z de la seule face S1. Les opérations nécessaires pour les prises de contact, la passivation, ... sont classiques et ne sont pas présentement décrites.

## Revendications

1. Dispositif semiconducteur de puissance symétrique, caractérisé par :
- une première couche (20) N(P) définissant une première face principale (S1),
- une deuxième couche (23) P(N) définissant une deuxième face principale (S2),
- la deuxième couche affleurant la première face au moyen de sillons (21) qui viennent de gravure,
- une troisième couche (22) P(N) formée entre la première et la deuxième couche, y compris sur les facettes des sillons (21), et déterminant avec la première couche une jonction (J2),

- une quatrième couche (24) P(N) diffusée sur la première face dans la première couche (20),

- une zone périphérique (25) P(N) diffusée sur la première face de manière à coiffer les sommets des sillons (21) et à former avec ceux-ci des caissons de liaison de la jonction (J2) avec la première face (S1).

2. Dispositif selon la revendication 1, dans lequel la zone périphérique (25) est formée simultanément avec la quatrième couche (24).

3. Dispositif selon la revendication 1 ou 2, dans lequel les sillons (21) sont en forme de V et sont obtenus par gravure anisotropique dans une tranche de silicium monocristallin ensuite rodée jusqu'au niveau de la première face (S1).

4. Dispositif selon l'une des revendications 1 à 3, dans lequel la deuxième couche (23) est obtenue par un dépôt du genre épitaxial et est essentiellement polycristalline.

5. Dispositif selon la revendication 4, dans lequel la deuxième couche (23) est surdopée P+-(N+) par une opération de diffusion à partir de la deuxième face principale (S2).

6. Dispositif selon la revendication 4 ou 5, dans lequel la deuxième couche (23) sert de source de dopants pour former la troisième couche (22).

7. Dispositif selon l'une des revendications 1 à 6, dans lequel des zones diffusées N+(P+) (26) sont formées dans la quatrième couche (24).

8. Procédé de fabrication du dispositif semiconducteur de puissance symétrique selon l'une des revendications 1 à 7, à partir d'une tranche de silicium monocristallin (20) N(P), caractérisé par les étapes suivantes :

- gravure de sillons (21) sur un côté (20a) de la tranche,

- dépôt épais d'une couche de silicium (23) P(N) sur le côté (20a) de la tranche dans lequel ont été gravés les sillons,

- rodage de la tranche jusqu'à une première face principale (S1) du dispositif qui affleure approximativement les sommets des sillons (21),

- diffusion P(N) sur la première face principale (S1) d'une couche (24) entourée par les sillons et diffusion d'une zone périphérique (25) P(N) coiffant les sommets des sillons (21).

9. Procédé selon la revendication 8, dans lequel la diffusion de la couche (24) est simultanée à celle de la zone périphérique (25).

10. Procédé selon la revendication 8 ou 9, dans lequel le dépôt épais de la couche de silicium (23) P(N) est effectué par un processus du genre épitaxial, cette couche étant essentiellement polycristalline.

11. Procédé selon la revendication 10, dans lequel la couche de silicium épitaxial (23) est surdopée P+(N+) par une opération de diffusion ultérieure à partir d'une deuxième face principale (S2) du dispositif.

12. Procédé selon l'une des revendications 8 à 11, dans lequel, après gravure des sillons et avant le dépôt épais de la couche (23), on forme par diffusion sur la tranche de silicium monocristallin (20) N(P) une couche (22) P(N).

13. Procédé selon la revendication 12, dans lequel la couche (22) P(N) diffusée concourt au surdopage P+(N+) de la couche épitaxiale (23).

14. Procédé selon l'une des revendications 8 à 11, dans lequel le dépôt épais de la couche (23) P-(N) sert de source de dopants pour engendrer une couche (22) P(N) intermédiaire entre la couche (23) et la couche de silicium monocristallin (20) N(P), simultanément à la diffusion de la zone périphérique (25) P(N).

FIG.1

FIG.2

FIG.3

FIG.4

FIG_5

FIG_6

FIG_7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN, vol. 7, no. 45 (E-160)[1190], 23 février 1983; & JP-A-57 196 571 (TOKYO SHIBAURA DENKI K.K.) 02-12-1982 * Résumé * --- | 1,7 | H 01 L 29/08 H 01 L 21/332 |
| A | IBM TECHNICAL DISCLOSURE BULLETIN, vol. 21, no. 4, septembre 1978, pages 1518-1519, New York, US; A.R. HARDER et al.: "Gas mixture control permits nonselective reactive ion etch" * Page 1518, paragraphe 2; figures * ----- | 3,4,8, 10 | |

DOMAINES TECHNIQUES RECHERCHES (Int. Cl.5)

H 01 L

Le présent rapport a été établi pour toutes les revendications

| Lieu de la recherche | Date d'achèvement de la recherche | Examinateur |
|---|---|---|
| LA HAYE | 26-02-1990 | HARRISON R.J. |